# EUROPÄISCHE PATENTSCHRIFT

(11) **EP 1 247 587 B1**
(45) Veröffentlichungstag und Bekanntmachung des Hinweises auf die Patenterteilung: **07.05.2008**
(21) Anmeldenummer: 02007724.4
(22) Anmeldetag: 05.04.2002
(51) Int. Cl.: C23C 16/455, H01L 21/205, H01L 21/285, H01L 21/365, H01L 21/443, B05D 3/04, B05D 7/24, B05D 1/30

(54) **Verfahren und Vorrichtung zum Behandeln und/oder Beschichten einer Fläche eines Gegenstandes**
Process and apparatus for treating and/or coating a surface of an object
Procédé et appareil pour traiter et/ou revêtir la surface d'un objet

(30) Priorität: 06.04.2001 DE 10117416; 05.09.2001 DE 10143587
(43) Veröffentlichungstag der Anmeldung: 09.10.2002
(73) Patentinhaber: SCHOTT Solar GmbH, 63755 Alzenau (DE)
(72) Erfinder: Kunz, Thomas, Dr., 63755 Alzenau (DE); von Campe, Hilmar, Dr., 61352 Bad Homburg (DE)
(74) Vertreter: Stoffregen, Hans-Herbert

(56) Entgegenhaltungen:
- US-A- 4 468 283
- US-A- 5 851 589
- PATENT ABSTRACTS OF JAPAN Bd. 0101, Nr. 70 (E-412), 17. Juni 1986 (1986-06-17) & JP 61 022621 A (SUMITOMO DENKI KOGYO KK), 31. Januar 1986 (1986-01-31)

## Beschreibung

Die Erfindung bezieht sich auf ein Verfahren zum Behandeln und/oder Beschichten einer Fläche eines in einem Raum angeordneten Substrats, wie eines Halbleiterbauelements wie Solarzelle, durch Beaufschlagen der zur Vertikalen ausgerichteten Fläche mit einem Gas, welches mit der Fläche wechselwirkt und Teilchen enthält, die auf der Fläche eine Schicht bilden und/oder mit der Fläche reagieren, wobei der Raum allseitig von einer Kopffläche, einer Bodenfläche und Längsseitenflächen begrenzt ist sowie eine Gaseinlassöffnung und eine Gasauslassöffnung aufweist. Ferner nimmt die ErfindungBezug auf eine Vorrichtung zum Beschichten und/oder Behandeln einer Fläche eines Substrats durch Beaufschlagen der Fläche mit einem Gas mit für die Beschichtung bzw. Behandlung erforderlichen Teilchen umfassend einen Raum, der allseitig von einer Kopffläche, einer Bodenfläche sowie Längsseitenflächen begrenzt ist und eine Gaseinlassöffnung und eine Gasauslassöffnung aufweist, sowie zumindest eine die Fläche erwärmende Wärmequelle.

Um Substrate bzw. Flächen dieser im CVD-Verfahren (Chemical Vapor Deposition) zu beschichten, können unterschiedliche Prinzipien zur Anwendung gelangen. So besteht die Möglichkeit, einen Gasfluss parallel zur Substratoberfläche zu führen. Dabei kann das Substrat feststehend oder bewegt sein. Durch die Gasführung entlang der Substratoberfläche ist die Tendenz zur schnellen Verarmung des Trägergases gegeben. Dabei sind bei feststehendem Substrat inhomogene Abscheideraten, inhomogene Schichtdicken sowie ungleichmäßige Dotierungen in Richtung der Schichtdicke und in der Schichtfläche festzustellen.

Beim bewegten Substrat ist zwar eine homogene Schichtdicke erzielbar, jedoch die Abscheiderate ist inhomogen. Auch ist eine ungleichmäßige Dotierung in Richtung der Schichtdicke festzustellen.

In Stauflussreaktoren strömt das einer Substratoberfläche zuzuführende Gas senkrecht von oben auf die zu beschichtende Fläche. Bei kleinen Substratflächen kann dabei eine homogene Abscheiderate erzielt werden. Auch hinsichtlich der Schichtdicke und der Dotierung in Richtung der Schichtdicke und in der Schichtfläche ist eine Homogenität festzustellen. Allerdings bereitet des Rückführen von reagiertem Gas bei Beschichtung großer Flächen Probleme, so dass bei Stauflussreaktoren gute Ergebnisse nur bei relativ kleinen Substratflächen erzielbar sind.

Um großflächige homogene Abscheidungen zu erzielen, werden Pancake-Reaktoren benutzt, die dem Prinzip des Stauflussreaktors ähnlich sind. Dies bedeutet, dass die zu beschichtende Fläche senkrecht angeströmt wird. Das Substrat selbst ist auf einem heißen Suszeptor angeordnet, so dass aufgrund der hierdurch bedingten Konvektion in der Gasatmosphäre eine Durchmischung und Homogenisierung des Gases erzielbar ist. Infolgedessen ergeben sich homogene Abscheideraten, homogene Schichtdicken sowie homogene Dotierungen in Richtung der Schichtdicke und der Schichtfläche. Die Homogenität kann zusätzlich dadurch erhöht werden, dass der Suszeptor beim Beschichten gedreht wird. Auch wenn ein entsprechendes Beschichtungsverfahren für große Flächen geeignet ist und reproduzierbare, hochwertige Epitaxieschichten ergibt, muss als nachteilig angesehen werden, dass die Gaszuführung aus der Mitte des Systems durch eine Bohrung in dem scheibenförmigen Suszeptor erfolgt und daher in der Anwendung auf die Wafer-Beschichtung beschränkt bleibt.

Entsprechende Verfahren bzw. zum Einsatz gelangende Reaktoren sind der Literaturstelle US-Z: Chemical Vapor Deposition for Microelectronics, Arthur Sherman, Noyes Publications, USA, S. 31 - 39, 150 - 174 zu entnehmen.

Um eine gute Schichtdicken-Homogenität zu erzielen, ist es bekannt, das zu beschichtende Substrat zu drehen, wodurch Inhomogenitäten in azimutaler Richtung herausgemittelt werden. Bei CVD-Verfahren im Halbleiterbereich werden daher Substrate rotiert oder zumindest bewegt. Rotation setzt dabei rotationssymmetrische Substrate, Substratträger bzw. Suszeptoren mit exakt definierter Form und geeigneter Massenverteilung voraus.

Bei den zuvor beschriebenen Techniken mit horizontalem CVD-Reaktor, Staufluss-Reaktor oder Pancake-Reaktor liegt das Substrat üblicherweise auf einem Suszeptor, der induktiv oder durch Lampen beheizt wird. Befindet sich das mit dem Substrat wechselwirkende Gas - häufig Nährgas genannt - oberhalb von diesem, wird eine Schichtabscheidung und damit die Schichtqualität von der Konvektion des Gases durch Erwärmung beeinflusst. Dabei kann die Konvektion sehr turbulent und unregelmäßig werden. Zudem kann dann, wenn heißes Gas mit zuströmendem kalten Gas in Berührung kommt, Kondensation bzw. Keimbildung in der Gasphase auftreten, die zu Nebel oder Staub führt. Staubförmige Ablagerungen auf der Schicht führen jedoch zu Defekten in einer wachsenden CVD-Schicht. Zudem können Partikel zu Defekten führen, die insbesondere in der Halbleitertechnologie und Solartechnik zu vermeiden sind.

Der US-A-4,468,283 sind zum Behandeln von Substraten Ätz- und CVD-Verfahren zu entnehmen. Die Substrate gehen von einem Träger aus, der mittig in einem Reaktionsraum angeordnet ist und von Reaktionsgas umströmt wird. Dabei befindet sich im Bodenbereich des Reaktionsraums eine Gaseintrittsöffnung und im Kopfbereich eine Gasaustrittsöffnung. Sämtliches in den Raum einströmende Gas wird durch die Gasaustrittsöffnung abgeführt, um sodann im Kreislauf der Gaseintrittsöffnung wieder zugeführt zu werden.

Um Substrate mittels CVD-Technik zu behandeln, sieht die US-A-5;851,589 einen Reaktionsraum vor, in dem das Reaktionsgas entweder horizontal entlang von horizontal angeordneten zu beschichtenden Substraten oder vertikal entlang von vertikal angeordneten Substraten geführt wird. Das Reaktionsgas wird über gegenüberliegende Seitenwandungen des Reaktionsraums ein- bzw. abgeführt.

Der vorliegenden Erfindung liegt das Problem zugrunde, ein Verfahren und eine Vorrichtung der eingangs genannten Art so weiterzubilden, dass eine hinreichende flächige bzw. räumliche Homogenität des Bereichs der Fläche, der behandelt wird, bzw. hinsichtlich der auf die Fläche aufzubringenden Beschichtung erzielbar ist. Auch soll bei der Beschichtung der Fläche eine gute Effizienz, d.h. ein ausreichendes Verhältnis von Beschichtungsrate zu Gasfluss gegeben sein. Des Weiteren soll mit einfachen Maßnahmen eine gezielte Gasführung und - strömung gegeben sein.

Erfindungsgemäß wird das Problem durch ein Verfahren der eingangs genannten Art im Wesentlichen dadurch gelöst, dass der Raum von der Fläche des Substrats begrenzt wird, die parallel oder in etwa parallel zu einer der Längsseitenfläche verläuft, dass das Gas in den Raum in dessen Kopfflächenbereich eingeleitet, nacheinander entlang der einen parallel oder in etwa parallel zu der Fläche des Substrats verlaufenden Längsseitenfläche sowie der Bodenfläche geführt und dabei erwärmt wird, aufgrund der Erwärmung durch Konvektion im wesentlichen laminar entlang der Fläche des Substrats strömt und der unmittelbar entlang der Fläche strömende. Teil des Gases im Kopfflächenbereich des Raums abgeführt und der verbleibende Teil des Gases mit neu eingeleitetem Gas vermischt und wieder in dem Raum im Kreislauf geführt wird, wobei die Fläche des Substrats zur Vertikalen unter einem Winkel α mit 0° ≤ α < 90° ausgerichtet wird.

Dabei ist insbesondere vorgesehen, dass ein Teil des unmittelbar entlang der Fläche des auch als Gegenstand zu bezeichnenden Substrats strömenden Gases aus dem Raum abgeführt und ein verbleibender Teil in dem Raum im Kreislauf geführt wird. Durch diese Maßnahmen wird der Teil des Gases aus dem auch als Reaktionsraum zu bezeichnenden Raum weggeführt, der in Bezug auf die Teilchen, die mit der Fläche wechselwirken, verarmt ist. Dabei wird insbesondere vorgeschlagen, dass der aus dem Reaktionsraum abgeführte Teil des Gases eine Schichtdicke aufweist, die kleiner als dreifache Dicke der Diffusionszone ist, in der Gasteilchen mit der Fläche des Gegenstandes wechselwirken. Der andere Teil des entlang der Fläche des Gegenstandes laminar strömenden Gases, dessen Teilchen mit der Fläche noch nicht in Wechselwirkung getreten sind, kann in dem Raum im Kreislauf geführt werden, ohne dass eine unkontrollierte Konzentrationsveränderung erfolgt. Das verbrauchte und abgeführte Gas wird durch neues kaltes Gas ersetzt, welches dem umlaufenden Gas vorzugsweise über einen Schlitz zugeführt wird. Um dabei sicherzustellen, dass der umlaufende Teilgasstrom ebenfalls schwerkraftbedingt entlang der oder in etwa parallel zu der Fläche des Gegenstandes verlaufenden Längsbegrenzungsfläche des Raums "herabfällt", wird das im Kreislauf geführte Gas mit kälterem frischen Gas vermischt und/oder die Längsbegrenzungsfläche gekühlt.

Durch die erfindungsgemäße Lehre werden die dem Stand der Technik zu entnehmenden Nachteile vermieden bei gleichzeitiger Erzielung erheblicher Vorteile: Dies sind die Abrührung verbrauchten Gases unmittelbar nach der Reaktion aus dem Reaktionsraum sowie die verbesserte Ausnutzung durch den Gasumlauf des unverbrauchten Gasanteils, ferner die Homogenität der Abscheiderate bei nicht rotierendem Substrat.

Im Vergleich zu den Verfahren, bei denen der Gasfluss horizontal zu einer nicht rotierenden Substratoberfläche geführt wird, ergibt sich bei einer abzuscheidenden Schicht eine homogenere Abscheiderate und damit homogenere Schichtdicke sowie Dotierung. Hinsichtlich der bekannten Verfahren, bei denen die Substrate in Rotation versetzt werden, ist eine homogenere Dotierung abzuscheidender Schichten gegeben. Ferner ist der konstruktive Aufwand geringer, da eine Rotation des Substrats nicht erfolgen muss. Im Vergleich zu Staufluss-Reaktoren ergibt sich der Vorteil, dass bei großen Substratflächen die Abscheidung hinsichtlich Abscheiderate, Schichtdicke und Dotierung homogener ist.

Aufgrund der erfindungsgemäßen Lehre und der Nutzung einer Konvektionsrolle sind rechteckige Reaktorgeometrien und daher rechteckige Substratflächen, die z. B. in der Dünnschicht-Technologie, in der Photovoltaik oder bei der Herstellung großer TFT-Bildschirme erforderlich sind, einsetzbar.

Liegt beim Pancake-Reaktor die heiße Substratfläche unten, so dass es schwerkraftbedingt zur Ablagerung kleiner Staubpartikel und daher zu Wachstumsfehlern in der Schicht kommen kann, ist dies aufgrund der erfindungsgemäßen Lehre durch die Position des Gegenstandes oberhalb des Gases ausgeschlossen.

Die Fläche des Gegenstandes selbst kann zum Beispiel durch Infrarotstrahler, Mikrowellen und/oder induktiv in einem Umfang erwärmt werden, so dass von dem Gegenstand ausreichend Wärme an das entlang der Fläche strömende Gas für die Ausbildung einer Konvektionsrolle abgegeben werden kann.

Durch die Ausbildung der Konvektionsrolle innerhalb des Raums ergibt sich des Weiteren eine Zone geringer Strömungsgeschwindigkeit, deren Breite ungefähr der zu behandelnden bzw. zu beschichtenden Fläche entspricht und somit auch zur Homogenität der zu behandelnden Fläche bzw. der auf dieser auszubildenden Beschichtung beiträgt.

Des Weiteren besteht die Möglichkeit, dass der Gegenstand parallel zu dem laminar entlang der zu behandelnden bzw. zu beschichtenden Fläche strömenden Gas bewegbar ist, so das im Durchlaufverfahren Flächen behandelt bzw. beschichtet werden können, auch solche, die eine Flächenerstreckung aufweisen, die größer als die unmittelbar dem Gas auszusetzende Fläche ist.

In Weiterbildung der Erfindung ist vorgesehen, dass zum Abscheiden einer siliziumcarbid- und/oder siliziumnitridhaltigen Schicht auf dem Gegenstand ein Gasgemisch von CH₃SiCl₃ und H₂ und/oder NH₃ bzw. SiH₂Cl₂, SiHCl₃, SiCl₄ und H₂ und/oder NH₃ verwendet wird, das mit der Fläche reagiert.

Zum Abscheiden einer Siliziumschicht ist vorgesehen, dass ein Gasgemisch von SiHCl₃ und H₂ verwendet wird. Auch besteht die Möglichkeit, einem verwendeten Gasgemisch ein Dotiergas bestehend aus zum Beispiel Diboran bzw. Bortrichlorid oder Aluminiumtrichlorid oder Galliumchlorid oder Indiumchlorid beizumischen.

Um auf einem Glassubstrat eine CulnGaSe₂- Schicht auszubilden ist vorgesehen, dass eine auf einem Glassubstrat abgeschiedene Cu, In, Ga-Schicht mit H₂Se enthaltendem Gas beaufschlagt wird.

Zur Abscheidung einer Zinnoxidschicht sieht die Erfindung vor, dass ein Glassubstrat bei Temperaturen um 400 °C bis 550 °C mit einem Gasgemisch aus Zinntetrachlorid und H₂O-Dampf beaufschlagt wird. Zur Abscheidung einer Siliziumoxidschicht sieht die Erfindung vor, dass ein Siliuziumsubstrat oder ein Si-beschichtetes Substrat oder eine p⁺-Si-Keimschicht bei Temperaturen von 400 °C bis 600 °C mit einem Gasgemisch aus SiCl₄ und H₂O-Dampf beaufschlagt wird

Ein weiterer Vorschlag der Erfindung sieht vor, dass eine Phosphorglasschicht durch Beaufschlagen einer Siliziumschicht mit POCl₃-haltigem Gas ausgebildet wird und sodann so erhaltene Phosphorglasschicht zur Eindiffusion von Phosphor getempert wird. Als Ergebnis erhält man eine homogen mit Phosphor dotierte Siliziumschicht.

Aber nicht nur das Ausbilden von Schichten, sondern auch das Behandeln von Flächen und Abtragen von Schichten dieser wird durch die erfindungsgemäße Lehre realisiert. So kann eine oberflächenseitige Schicht des Gegenstandes durch Entlangströmen eines HF-haltigen Gases abgetragen werden. Eine Siliziumoxid-Schicht, die bei der Herstellung von Dünnschicht-Solarzellen entsteht und wieder entfernt werden muss, kann zum Beispiel durch Entlangströmen von HF-hahigem Gas gleichmäßig abgetragen werden. Auch kann eine Siliziumoxid-Schicht durch parallel zu dieser strömender und mit dieser reagierender HF- und/oder H₂O-dampf-haltiger Luft gleichmäßig abgetragen werden. Schließlich ist insbesondere vorgesehen, dass eine Siliziumoxid-Schicht auch durch Entlangströmen von H₂-haltigem Gas bei einer Temperatur T₃ mit T₃ ≥ 1000 °C reduziert und dadurch abgetragen wird.

Eine Vorrichtung zum Beschichten und/oder Behandeln einer Fläche eines Substrats durch Beaufschlagen der Fläche mit einem Gas mit für die Beschichtung bzw. Behandlung erforderlichen Teilchen der eingangs genannten Art zeichnet sich dadurch aus, dass die Fläche des Substrats Begrenzungsfläche des Raums ist, dass die Fläche parallel oder in etwa parallel zu einer der Längsseitenflächen verläuft, dass die Fläche unter einem Winkel α mit 0° ≤ α < 90° zur Vertikalen verläuft und dass die Gaseinlass- und die Gasauslassöffnung derart im Kopfbereich des Raums angeordnet sind, dass der unmittelbar entlang der Flache des Substrats strömende Teil des Gases im Kopfflächenbereich des Raums abgeführt und der verbleibende Teil des Gases mit neu eingeleitetem Gas vermischt und wieder in dem Raum im Kreislauf geführt werden kann. Dabei ist insbesondere vorgesehen, dass das Gas in den Raum derart durch Schwerkraft und Konvektion führbar ist, dass das Gas entlang der Fläche des Gegenstandes laminar oder im Wesentlichen laminar strömt.

Die Gasaustrittsöffnung selbst sollte sich über oder nahezu über die gesamte Breite der Fläche und parallel zu dieser erstrecken, also schlitzförmig ausgebildet sein.

Die Gaseintrittsöffnung ist bevorzugterweise im Bereich der Längsbegrenzungswandung, die parallel oder in etwa parallel zu der Fläche des Gegenstandes verläuft, angeordnet, wobei eine schlitzförmige Ausbildung gleichfalls zu wählen ist.

Die Fläche des Gegenstandes, die Längsbegrenzungsfläche sowie die vorzugsweise senkrecht zu diesen verlaufenden Kopf- und Bodenflächen sind derart zueinander ausgerichtet und/oder die Erwärmung dieser ist dergestalt, dass das in dem Raum strömende Gas eine Konvektionsrolle bildet.

Des Weiteren ist vorgesehen, dass die zu behandelnde bzw. zu beschichtende Fläche des Gegenstandes eine Öffnung des Raums insbesondere dichtend verschließt. Des Weiteren kann der Raum selbst gegenüber Umgebung einen leichten Überdruck aufweisen, um ein Eindringen von Gas auszuschließen.

Zur Herstellung eines Halbleiterschichtsystems unter Verwendung der erfindungsgemäßen Vorrichtung zeichnet sich die Erfindung durch die Verfahrensschritte aus:
- Abscheiden einer SiC und/oder Siliziumnitrid enthaltenden Schicht auf einem Substrat aus zum Beispiel Silizium, Keramik oder Graphit bei einer Substrattemperatur T mit 900 °C ≤ T ≤ 2000 °C, insbesondere 1200 °C ≤ T ≤ 1600 °C, durch CVD in dem Raum,
- Ausbilden einer mit einem Element der Gruppe III des Periodensystems dotierte Siliziumschicht (p⁺) in dem Raum,
- Kristallisieren der dotierten Siliziumschicht durch Aufschmelzen dieser (ggf. außerhalb des Raums) und
- Epitaxieren der mit einem Element der Gruppe III dotierten multikristallinen Siliziumschicht (p) mit Körnern in der Größenordnung von 0,1 bis 10 mm mit einer photoempfindlichen Silizium-Schicht (p-Schicht).

Ferner kann auf ein entsprechend hergestelltes Schichtsystem eine n-dotierte Schicht, elektrisch leitender Frontkontakt und/oder eine Antireflexionsschicht aufgebracht werden, wobei sowohl die Endschicht als auch die Antireflexionsschicht in dem Raum ausgebildet werden kann.

Ferner kann auf der p⁺-Schicht vor deren Kristallisation eine 0,1 bis 5 µm, vorzugsweise 1 bis 2 µm dicke Siliziumoxid-Sclücht ausgebildet werden, um sodann die p⁺-Schicht aufzuschmelzen und insbesondere nach dem Zonenschmelzverfahren zu rekristallisieren, wobei nach der Kristallisation die Oxidschicht mit HF- und/oder H₂O-haltigem Gas abgetragen wird, um eine Keimschicht multikristalliner Struktur mit Körnern der Größenordnung 0,1 bis 10 mm freizulegen, auf die die p-Schicht epitaktisch abgeschieden wird.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:
- Fig. 1: eine Prinzipdarstellung einer Vorrichtung zum Behandeln bzw. Beschichten einer Fläche eines Gegenstandes,
- Fig. 2a und b: die Anordnung gemäß Fig. 1 in unterschiedlichen Ausrichtungen zur Vertikalen,
- Fig. 3: eine weitere Prinzipdarstellung einer der Fig. 1 entsprechenden Anordnung,
- Fig. 4: eine Darstellung der Abscheiderate auf einer Fläche in Abhängigkeit von deren Neigungswinkel und
- Fig. 5: eine c-Si-Dünnschichtsolarzelle.

Anhand der Erläuterungen der den Zeichnungen zu entnehmenden Figuren soll die erfindungsgemäße Lehre zum Beschichten bzw. Behandeln von Flächen von Gegenständen, insbesondere Substratoberflächen erfolgen. Dabei wird vorrangig auf CVD-Verfahren zum Abscheide von Silizium eingegangen. Hierdurch soll jedoch die erfindungsgemäße Lehre nicht eingeschränkt werden. Anstelle von abzuscheidenden Stoffen ist auch eine chemische oder physikalische Veränderung einer bestehenden Schicht durchführbar, wie diese zum Beispiel im Zusammenhang mit Trocknungsprozessen erfolgen können. Auch eine chemische Umwandlung einer bereits bestehenden Schicht ist mit dem erfindungsgemäßen Verfahren realisierbar.

Wesentliches Merkmal der Erfindung ist darin zu sehen, dass ein Gas, das Elemente enthält, die mit einer zu behandelnden bzw. zu beschichtenden Fläche wechselwirken, in einem Raum - nachstehend Reaktorraum genannt - derart geführt werden, dass das Gas, das auch als Träger- oder Nährgas zu bezeichnen ist, durch Konvektion entlang der Fläche geführt wird, wobei eine laminare Strömung ausgebildet wird.

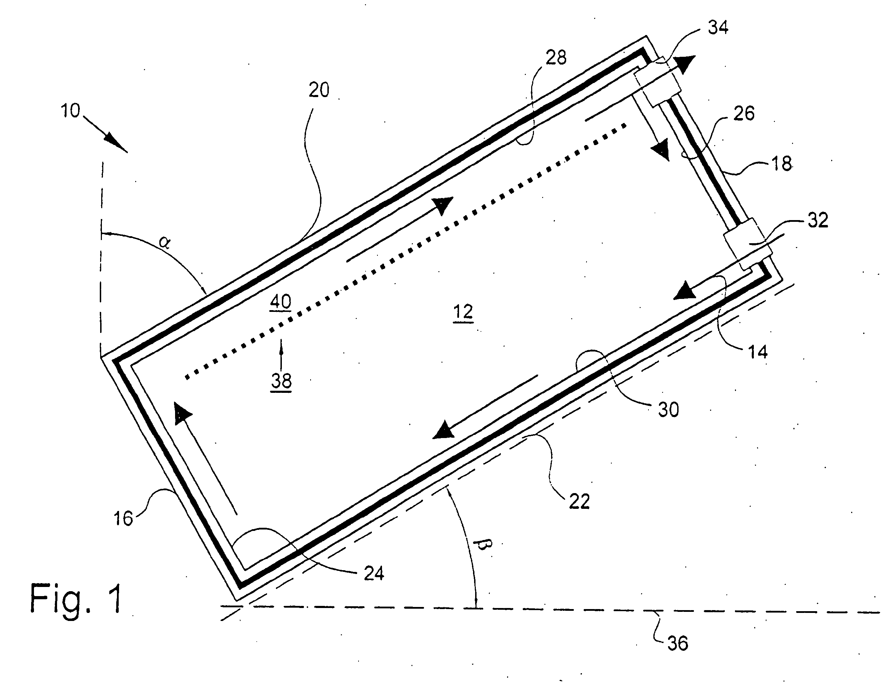

In Fig. 1 ist rein prinzipiell eine Anordnung 10 in Form eines Reaktors dargestellt, in dessen Innenraum 12 ein entlang der Pfeile 14 strömendes Gas geführt wird. Der Reaktor 10 wird neben nicht dargestellten Seitenwandungen von einer Bodenwandung 16, einer Kopfwandung 18, einer Trägerwandung 20 und einer parallel oder in etwa parallel zu dieser verlaufenden Längsseitenwandung 22 begrenzt. Die Trägerwandung 20 kann ein Substrat sein, das rauminnenseitig mit dem Gas bzw. den in diesem vorhandenen Elementen wechselwirken wie reagieren kann. Auch kann die Trägerwandung 20 selbst als Substrat ausgebildet sein. Somit wird der Innenraum 12 des Reaktors 10 von Bodenfläche 24, Kopffläche 26, Substratfläche 28 und Längsbegrenzungsfläche 30 begrenzt, soweit die entsprechenden Wandungen 16, 18, 20, 22 zeichnerisch dargestellt sind.

In der Kopfwandung 18 sind eine Gaseintritts- oder -einlassöffnung 32 und eine Gasaustritts- oder -auslassöffnung 34 vorgesehen. Dabei verläuft die Einlassöffhung 32 im Bereich der Langsseitenwandung 22 und die Auslassöffnung 34 im Bereich der Substratfläche 28.

Erfindungsgemäß ist der Reaktor 10 derart zur Vertikalen bzw. zur Horizontalen 36 geneigt, dass die Substratfläche 28 zur Vertikalen einen Winkel α beschreibt, der vorzugsweise im Bereich zwischen 0° und fast 90° verläuft. Mit anderen Worten beschreibt der Reaktor 10 zur Horizontalen einen Winkel β mit 0° < β ≤ 90° .

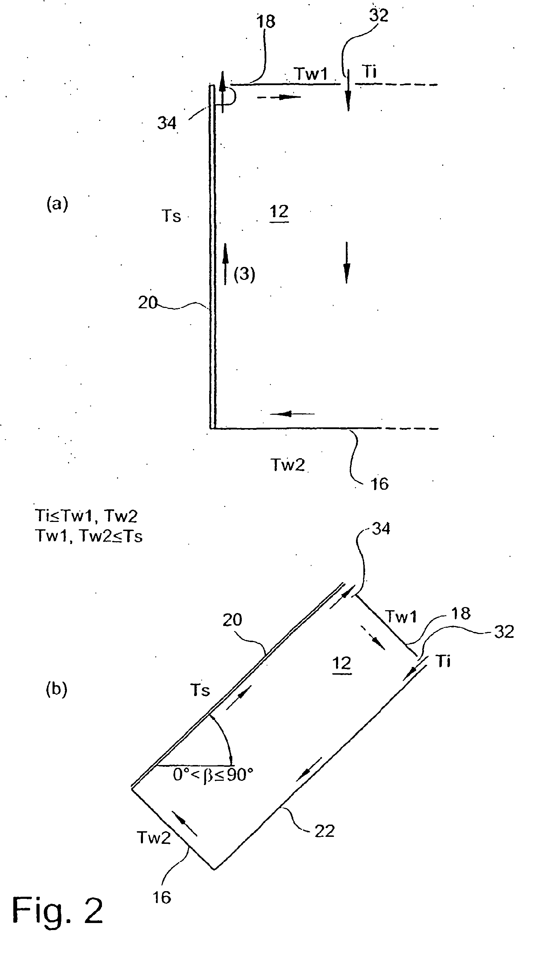

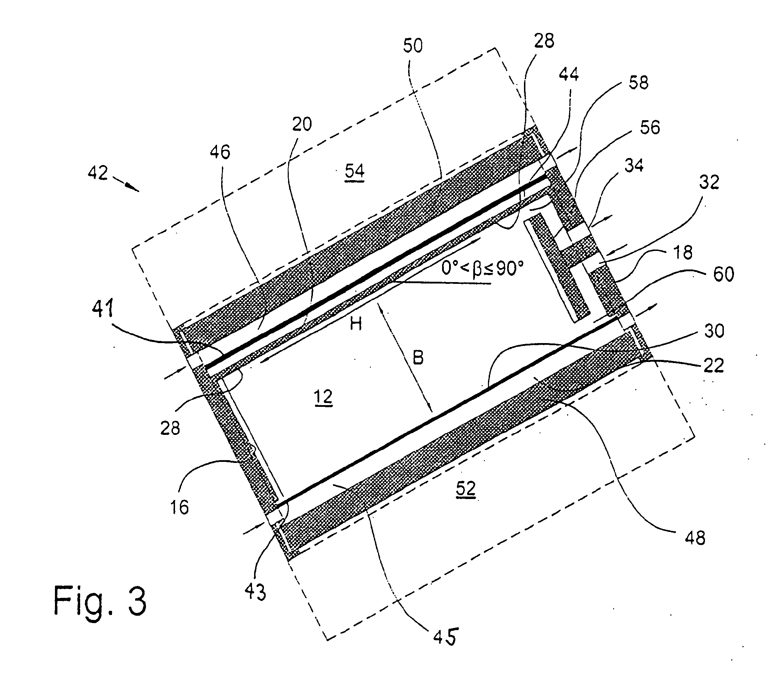

Verschiedene Neigungspositionen des Reaktors 10 sind rein prinzipiell den Fig. 2 und 3 zu entnehmen.

Über die Einlassöffnung 32 strömt vorzugsweise kaltes Gas in den Reaktorinnenraum 12, um schwerkraftbedingt entlang der Längsseiten- oder -begrenzungsfläche 30 zur Bodenfläche 24 zu gelangen, in der das Gas umgelenkt wird, um sodann zur Substratfläche 28 geführt zu werden und entlang dieser zu strömen. Die Auslassöffnung 34 ist nun derart beabstandet zur Substratfläche 28 angeordnet bzw. erstreckt sich von dieser ausgehend in einem Umfang, dass nur derjenige Teil des Gases weggeführt wird, das bzw. dessen Elemente mit der Substratfläche 28 wechselgewirkt hat, also der Teil des Gases, aus dem im Falle einer Beschichtung die Elemente auf der Substratfläche 28 abgeschieden worden sind. Da die Substratfläche 28 bzw. das Substrat erwärmt ist, und zwar auf eine Temperatur Tₛ, die größer als die Einlasstemperatur Tᵢ des Gases ist, erfolgt während des Strömens entlang der Längsbegrenzungsfläche 30 und der Bodenfläche 24 ein Erwärmen des Gases mit der Folge, dass dieses entlang der Substratfläche 28 konvektionsbedingt strömt und sich eine laminare Strömung ausbildet. Folglich bildet sich entlang der Substratfläche 28 eine Gasschicht 38 aus, die substratflächennah, also im Schichtbereich 40 im Falle einer Beschichtung der Substratfläche 28 in Bezug auf die Elemente verarmt ist, die auf der Substratfläche 28 abgeschieden werden. Dieser Schichtbereich 40 -auch Zone genannt- wird über die Auslassöffnung 34 weggeführt, wohingegen der außerhalb des Schichtbereichs 40 verbleibende Gasanteil, dessen Konzentration an den Elementen, die sich auf der Substratfläche 28 abscheiden könnten, in der Zusammensetzung etwa der des über die Einlassöffnung 32 zuströmenden Gases entspricht.

Wie insbesondere durch die in den Fig. 1 und 2 eingezeichneten Pfeile verdeutlicht werden soll, bildet das den Reaktionsraum 12 durchströmende Gas eine Konvektionsrolle, wobei ein laminares Strömen entlang der Substratfläche 28 erfolgt.

Da das Substrat bzw. die Substratfläche 28 oberhalb des strömenden Gases angeordnet ist, wird verhindert, dass größere Partikel auf die zu beschichtende Substratfläche 28 gelangen. Weitere Vorteile ergeben sich daraus, dass die Temperatur des Substrats zumindest gleich, insbesondere jedoch höher als die Temperatur der verbleibenden Wandungen 16, 18, 20 und des über die Einlassöffnung 32 zugeführten Gases ist. Das Anordnen des Substrats oberhalb des Reaktionsgases bewirkt sodann eine Temperaturverteilung, die eine stabile Gasströmung, also den gewünschten laminaren Verlauf entlang der Substratfläche 28 gewährleistet.

Mit anderen Worten wird zur Erzielung einer homogenen Abscheiderate die Eigenschaft der konvektiven Strömung für ein Beschichtungsverfahren gezielt genutzt. Gleiches gilt für den Fall einer Behandlung wie zum Beispiel dem Abtragen von Schichten von einem Substrat.

Das über die Einlassöffnung 32 zugeführte Gas ist kühl und strömt bevorzugt schwerkraftbedingt entlang der Längsbegrenzungsfläche 30 zum Boden. Dementsprechend sollte die Längsseitenwandung 22 und damit der Reaktor 10 geneigt verlaufen. Dabei verläuft der Neigungswinkel α zur Vertikalen vorzugsweise im Bereich zwischen 0° und 80° bzw. der Kipp-winkel β zur Horizontalen zwischen 90° und 10°.

Während des Entlangströmens entlang der L-2ingsbegren7ungsfläche 30 erfolgt ein allmähliches Erwärmen des Gases. Sodann erfolgt ein Umlenken entlang der Bodenfläche 24, damit schließlich das Gas entlang der Substratfläche 28 konvektionsbedingt aufwärts in Richtung der Kopffläche 26 strömt. Somit wird das Gas erst dann an der Substratfläche 28 vorbeigeführt, nachdem es sich vorher erwärmt hat. Durch das Vorbeiströmen des Gases am heißen Substrat erwärmt sich das Gas innerhalb einer Zone von einigen cm bis 10 cm Breite, so dass hierdurch der Auftrieb und die treibende Kraft für die Ausbildung der Konvektionsrolle gegeben ist. Hierdurch bedingt erfolgt ein dichtes Vorbeiströmen des heißen Gases an der Substratfläche 28. Dies führt zur chemischen Reaktion in Nähe der Substratoberfläche 28. Hieraus ergeben sich Vorteile in Bezug auf Beschichtungsrate und Ausbeute. Die Neigung des Substrats unterstützt die Strömung, wobei die Geschwindigkeit mit wachsendem Neigungswinkel zunimmt.

Auch ist anzumerken, dass das Gas entlang des Substrats immer heißer wird und somit die Strömungsgeschwindigkeit immer mehr zunimmt. Hierdurch wird der Verarmungseffekt ausgeglichen.

Erwähntermaßen verläuft die Gasauslassöffnung 34 in unmittelbarer Nähe der Substratfläche 28, wobei eine schlitzförmige Geometrie parallel zur Substratfläche 28 gewählt ist. Somit kann verbrauchtes Gas unmittelbar nach Vorbeistreichen entlang der Substratfläche 28 abgeführt werden. Dabei ist die Breite der Auslassöffnung 34 bzw. des Austrittsschlitzes bzw. der Abstand zur Substratfläche 28 derart gewählt, dass allein Gas abgeführt wird, das hinsichtlich seiner Nährkomponente verarmt ist. Somit kann derjenige Teil des Gases, das im größeren Abstand vom Substrat bzw. der Substratfläche 28 an dieser vorbeiströmt und somit unverbraucht und angewärmt ist, entlang der Kopffläche 26 zur Einlassöffnung 32 strömen, um dort mit neu zugerührtem Gas vermischt zu werden. Hierdurch wird die Ausbeute erhöht. Gleichzeitig vermindert sich das Konzentrotionsgefälle entlang der Substratfläche 28.

Die Breite des Spaltes der Auslassöffnung 34 sollte derart gewählt werden, dass die Gasschicht, die entlang der Substratfläche 28 strömt, abgeleitet werden kann, die in ihrer Breite der Diffusionszone der Elemente entspricht, die mit der Substratfläche 28 wechselwirken.

Prinzipiell wird dies durch die Fig. 1 verdeutlicht. So wird der Schichtbereich 40 bzw. die Schicht, in der das durch den Reaktionsraum 12 ge:Rihrte Gas hinsichtlich seiner Nährkomponente verarmt ist, über die Auslassöffung 34 weggeführt. Der verbleibende Teil strömt im Kreislauf, folgt also der Konvektionsrolle.

Durch das im Kreislauf strömende unverbrauchte Gas entsteht ein weitgehend homogen zusammengesetztes Gasgemisch im Reaktionsinnenraum 12 vor den Schichtbereich 40 bzw. der Diffusionszone. Somit wird stetig unverbrauchtes Material nachgeliefert. Dies führt zu einer Homogenisierung der Abscheiderate. Gleichzeitig ist sichergestellt, dass das Gas zumindest im Bereich der Bodenfläche 16 oder der Substratfläche 28 in hinreichendem Umfang erwärmt ist, so dass eine Zone "mit verminderter Reaktionssgeschwindigkeit" nicht entstehen kann. Gegebenenfalls muss das Gas im Bereich der Substratfläche 28 zusätzlich aufgeheizt werden, um ein gleichmäßiges Temperaturprolil zu erzeugen, das sicherstellt, dass eine laminare Strömung in der Diffusionsschicht bzw. dem Schichtbereich 40 gegeben ist.

Der Fig. 3 ist eine Anordnung 42 zu entnehmen, in der eine Siliziumschicht auf einem Substrat 44 abgeschieden werden soll. Dabei entspricht die Anordnung 42 der der Fig. 1 vom Prinzip her, so dass für gleiche elemente gleiche Bezugszeichen verwendet werden.

Abweichend von der Ausführungsform der Fig. 1 ist in Fig. 3 zur Abdichtung des Reaktionsinnenraumes 12 eine doppelwandige Struktur aus Quarzplatten 41, 43 vorgesehen. Zwischenraum zwischen Quarzplatte 41 der Längsseitenwandung 22 und einer äußeren Quarzglaswand 48 bildet einen Kanal 45, der von einem Intergas wie N₂-Gas durchströmt werden kann. Durch Spülen des Zwischenraumes wird die Quarzplatte 43 von Wandbelägen, hervorgerufen durch Reaktionsprodukte aus dem Reaktionsinnenraum 12, freigehalten. Darüber hinaus verläuft rückseitig entlang des Substrats 44 ein Kühlkanal 46, der ebenfalls von zum Beispiel N₂-Gas durchströmt werden kann. Der Kühlkanal 46 wird außenseitig von der Quarzplatte 43 begrenzt. Entlang der Längsseitenwandung 22 bzw. des Substrats 40 verlaufen sodann Quarzglaswandungen 48, 50, die von Infrarot- bzw. Wärmestrahlung durchdrungen werden können. Hierzu können entlang der aus Quarzglas bestehenden Wandungen 48, 50 Heizquellen 52, 54 zum Beispiel in Form von Lampen angeordnet sein. Die Bodenwandung 16 sowie die Kopfwandung 18 können aus Edelstahl bestehen.

Über die Heizung 52, 54 kann das Substrat 44 auf 900° C bis 1600° C aufgeheizt werden. Die Strahlung gelangt durch die Quarzglaswandungen 48, 50 in den Reaktorinnenraum 12. Dabei werden die auch als Fenster zu bezeichnenden Quarzglaswandungen 48, 50 durch das in den Kühlkanälen 44, 46 strömende kalte Gas auf in etwa unter 900° C gekühlt. Der Reaktionsinnenraum 12 selbst ist mit Quarzglas ausgekleidet, wobei die obere - in den Fig. linke - Fläche von der Substratfläche 28 gebildet wird. Hierzu kann das Substrat 44 in einer entsprechenden Halterung in dem Reaktionsinnenraum 12 angeordnet sein. Dabei kann das Substrat 44 in die Zeichenebene hinein bzw. aus dieser heraus verschoben werden, um quasi im Durchlaufverfahren eine Siliziumschicht auf dem Substrat aufzutragen.

Zum Beschichten wird in dem Reaktionsinnenraum 12 über die Einlassöffnung 32 Gas eines Gemisches von Wasserstoff (ca. 20 bis 2000 slm) und Trichlorsilan (ca. 1 bis 200 slm) bei Atmosphärendruck eingeführt.

Wie aus der Prinzipdarstellung der Fig. 3 ersichtlich ist, weicht die Anordnung der Einlassöffnung 32 bzw. der Auslassöffnung 34 scheinbar von der Anordnung 10 nach der Fig. 1 ab. So sind die Einlassöffnung 32 und die Auslassöffnung 34 unter einem Abweiser 56 angeordnet, der sich entlang der Kopfwandung 18 erstreckt. Der Abweiser 56 erstreckt sich dabei entlang der Kopfwandung 18 in einem Umfang, dass sich substratseitig bzw. längsbegrenzungsflächenseitig jeweils ein Spalt 58, 60 ergibt, der der Einlassöffnung 32 bzw. AuslassÖffnung 34 in der Dimensionierung und Anordnung 10 gemäß Fig. 1 entspricht. Somit werden ebenfalls aus dem Reaktionsinnenraum 12 nur diejenigen Gasanteile abgeführt, die unmittelbar entlang der Substratfläche 28 strömen und in Bezug auf die Nährkomponenten verarmt sind.

Anzumerken ist noch, dass der Reaktionsinnenraum 12 gegenüber der Atmosphäre einen Überdruck aufweisen kann.

Die erfindungsgemäße Lehre soll nachstehend an weiteren Ausführungsbeispielen verdeutlicht werden.

### 1. CVD-Abscheidung einer Si-Schicht auf einem großflächigen Substrat

Zunächst wird ein Substrat 44, das vorzugsweise aus Graphit oder aus einer gegebenenfalls Graphit enthaltenden Keramik besteht oder Graphit enthält, entsprechend der Fig. 3 durch den Reaktionsinnenraum 12 geführt, wobei eine Erwärmung auf Temperaturen von ca. 1000 °C bis 1200 °C erfolgt. In den Reaktionsinnenraum 12 wird kaltes Reaktionsgas aus Trichlorsilan und H₂ durch die Gaseinlassöffnung 32 und den Spalt 60 entlang der Längsbegrenzungsfläche 30 geführt. Dadurch, dass das Gas während des Entlangströmens an der Längsbegrenzungsfläche 30 und der Bodenfläche 16 erwärmt wird und hierdurch einen Auftrieb erfährt, erfolgt in dem Reaktionsinnenraum 12 eine Konvektion mit der Folge, dass das Gas entlang der Substratfläche 28 strömt, so dass ein Abscheiden einer Siliziumschicht auf dem Substrat 44 erfolgt.

Die Höhe H des Reaktionsinnenraums 12 beträgt im Beispiel ungefähr 400 mm und die Breite B des Reaktionsinnenraums 12 in etwa 200 mm.

Durch die Reaktion wird Gas innerhalb einer schmalen Zone, die dem Schichtbereich 40 entspricht, aufgebraucht. Diese unter Normaldruck ca. 1 bis 2 cm breite Zone wird durch den Auslassspalt 56 im Kopfbereich des Substrats abgeführt, wobei die Spaltbreite auf die Breite der Zone des reagierenden Gases einstellbar ist. Durch die geneigte Anordnung des Substrats 44 wird eine turbulente Strömung sowie eine Durchmischung von unverbrauchten und verbrauchtem Gas unterbunden, so dass unerwünschte Produkte auf kurzem Wege entweichen können.

In dem Bereich unterhalb der Zone (Schichtbereich 40) befindet sich unverbrauchtes Gas, das durch den Abweiser 56 zur Längsbegrenzungswandung 40 umgelenkt wird. Gleichzeitig erfolgt entlang des Abweisers 58 ein Abkühlen, so dass zusätzlich durch das Vermischen mit kaltem frischen Gas, das über die Einlassöffnung 32 bzw. den Spalt 60 in den Reaktionsinnenraum 12 eingeführt wird, schwerkraftbedingt ein "Herabfallen" von Gas entlang der Längsbegrenzungsfläche 30 erfolgt. Danach beginnt der gleiche Kreislauf, d. h. durch die sich in dem Reaktionsraum 12 ausbildende Konvektionsrolle wird unverbrauchtes Gas entlang der Substratfläche 28 geführt, um die gewünschte Siliziumschicht auf der Substratoberfläche 28 auszubilden.

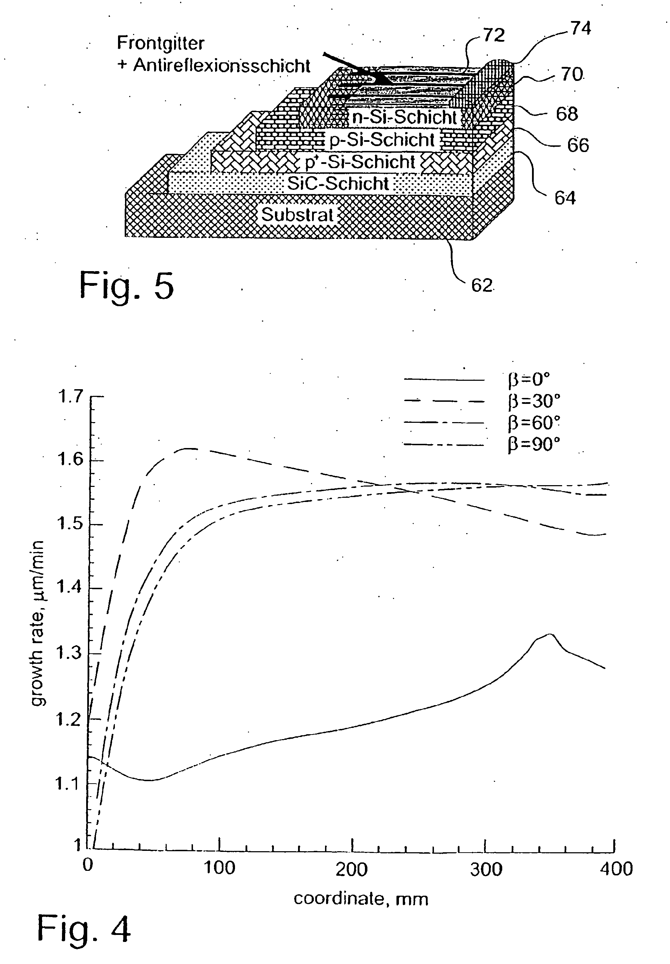

Durch die ständige Erneuerung von Gas entsteht ein Bereich mit sehr homogener Konzentration im Raum vor dem Schichtbereich 40, so dass über die gesamte Substratfläche 28 eine homogene Abscheiderate gewährleistet ist. Dabei haben Versuche ergeben, dass die Abscheiderate stabil und in weiten Grenzen unabhängig vom Neigungswinkel β ist. Vorzugsweise beläuft sich der Winkel β zwischen 10° und 90° und wird insbesondere in dem Bereich 60° ≤ β ≤ 90° sehr homogen, wie die Fig. 4 verdeutlicht. Stabile, d. h. vom Winkel relativ unäbhängige, Beschichtungsraten sind daher in diesem Winkelbereich zu erreichen.

So ist in Abhängigkeit von dem Kippwinkel β zur Horizontalen die Abscheiderate in µm pro min. im Abstand vom bodenseitigen Rand des Substrats 44 aufgetragen. Als Substrat 44 wurde ein solches benutzt, das eine Länge von 400 mm aufweist, die gleich dem Abstand zwischen Bodenwandung 16 und Kopfwandung 18 entspricht. Man erkennt, dass nach geringem Abstand von der Bodenwandung 16 die Abscheiderate nahezu konstant ist. Einzig und allein bei einem Kippwinkel β von 0° kann sich die Konvektionsrolle nicht entwickeln. Daraus ergibt sich eine Instabilität.

Das entsprechend dem zuvor erläuterten Beispiel beschichtete Substrat 44 weist somit mit Ausnahme eines bodenseitigen Randbereichs von zum Beispiel einer Länge von 100 mm (Beginn der CVD-Abscheidung) eine homogene Beschichtung auf.

### 2. CVD-Abscheidung eines Halbleiterschichtsystems für eine Si-Dünnschichtsolarzelle

Mit dem erfindungsgemäßen Verfahren bzw. der entsprechenden Vorrichtung kann ein Halbleiterschichtsystem für eine kristalline Siliziumdünnschicht-Solarzelle hergestellt werden, wie dieses prinzipiell der Fig. 5 zu entnehmen ist. Das Schichtsystem besteht aus einem Substrat 62, das vorzugsweise aus Graphit bzw. aus einer Graphit enthaltenden Keramik besteht oder Graphit enthält. Die Basis des Schichtsystems wird gebildet durch das Substrat 62, eine elektrisch leitfähige SiC-Rückkontaktschicht 64 bzw. alternativ eine elektrisch isolierende Zwischenschicht im Falle eines integrierten verschalteten Dünnschichtsolarmoduls, eine hochdotierte Silizium-Keimschicht 66 mit einer grobkristallinen Kornstruktur und eine darauf epitaktisch abgeschiedene photoempfindliche Siliziumschicht 68. Mit einem entsprechenden Schichtsystem können die aus der kristallinen Siliziumtechnologie bekannten Solarzellentypen hergestellt werden, wobei sowohl MIS-Inversionsschicht-Solarzellen und Solarzellen mit pn-Übergang als Teststrukturen erfolgreich verwendet werden können. So ist in der Fig. 5 beispielhaft eine Solarzelle mit pn-Übergang dargestellt, also mit dem weiteren Schichtaufbau diffundierter Emitter 70, metallisches Frontgitter 72 sowie Antireflexschicht 74.

Zur Herstellung des Schichtsystems gemäß Fig. 5 werden mit der erfindungsgemäßen Lehre nachfolgende Prozessfolge durchgeführt:
- Herstellung Substrat,
- CVU-Abscheidung Zwischenschicht (SiC oder Siliziumnitrid oder Materialgemisch aus beiden Komponenten),
- CVD-Abscheidung p⁺-Si-Keimschicht,
- Aufbringen einer SiOₓ-Deckschicht,
- Kristallisation der p⁺-Si-Keimschicht,
- Entfernen der SiOₓ-Deckschicht,
- Epitaxie (CVD) der photovoltaisch aktiven Si-Schicht,
- Solarzellenstrukturen (zum Beispiel MIS-IL-Prozesse, pn-Prozesse).

Im Einzelnen werden die Prozesse wie folgt durchgeführt:

### a) Zwischenschicht

Ein Substrat mit einer Kantenlänge von vorzugsweise 100 mm bis 1000 mm, vorzugweise zwischen 300 mm und 500 mm, das vorzugsweise aus Graphit besteht oder Graphit enthält bzw. aus einer gegebenenfalls Graphit enthaltenden Keramik besteht, wird auf eine Substrattemperatur von ca. 1300 °C bis 1600 °C erhitzt. Währenddessen wird ein Teil des Reaktionsgases aus Methyltrichlorsilan und H₂ durch die Gaseinlassöffnung 32, 60 in den Reaktionsinnenraum 12 eingeführt. Nach dem zuvor beschriebenen Mechanismus bildet sich eine Konvektionsrolle und damit gekoppelt eine Diffusionszone (Schichtbereich 40) und eine Zone umlaufenden unverbrauchten Gases aus. Hierdurch wird die SiC-Schicht 64 auf dem Substrat 62 abgeschieden. Durch Zugabe geringer Mengen Stickstoff kann eine elektrisch leitfähige, stickstoffdotierte SiC-Zwischenschicht erzeugt werden. Die Schichtdicke liegt zwischen 1 µm und 100 µm, vorzugsweise zwischen 30 µm und 50 µm.

Wird das Substrat auf 1200 °C erhitzt und dazu das Reaktionsgas bestehend aus einem Chlorsilan und NH₃ bei einem Unterdruck von 40 bis 100 mbar unter Atmosphärendruck eingeleitet, so wird eine Schicht aus Siliziumnitrid abgeschieden. Aus der Kombination beider Stoffe kann im Unterdruck ein Schichtmaterialgemisch, das SiC und Siliziumnitrid enthält, hergestellt werden. Die Schichten (SiC, Siliziumnitrid oder Materialgemisch) bilden eine elektrisch isolierende Zwischenschicht und Barriere für Verunreinigungen. Mit Stickstoff dotiertem SiC kann eine elektrisch leitfähige Zwischenschicht erzeugt werden. Die Schichtdicke liegt zwischen 1 µm und 100 µm, vorzugsweise bei 30 µm bis 50 µm.

### b) Keimschicht

Auf der zuvor wiedergegebenen SiC-Zwischenschicht 64 wird eine hoch mit Bor dotierte Si-Schicht (p⁺-Si) abgeschieden. Dazu werden die oben erwähnten Temperatur- und Gasflussparameter verwendet. Die Substrattemperatur sollte ca. 1000 °C bis 1200 °C, vorzugsweise 1100 °C betragen. Das Reaktionsgas besteht aus Trichlosilan und H₂ mit einem Zusatz von BCl₃. Die so hergestellte Schicht weist eine Dicke zwischen 1 µm und 100 µm, vorzugsweise zwischen 30 µm und 50 µm auf.

Die in dem Reaktionsinnenraum 12 CVD-abgeschiedene p⁺-Si-Schicht wird mit einer 0,1 µm bis 5 µm, vorzugsweise 2 µm dicken Siliziumoxid- bzw. Siliziumnitridschicht abgedeckt. Danach wird die hochdotierte Si-Schicht außerhalb des Reaktionsraumes aufgeschmolzen und mit einem Zonenschmelzverfahren (ZMR = zone melting and recrystallization) lateral kristallisiert, wodurch Korngrößen von einigen 100 µm bis in den cm-Bereich erhalten werden. Die kristallisierte Schicht bildet die Keimschicht 66. Die Deckschicht verhindert, dass sich die Schmelze zu Tropfen zusammenzieht. Nach der Kristallisation wird die Siliziumoxid- bzw. Siliziumnitrid-Schicht abgeätzt. Dies kann ebenfalls im Reaktionsinnenraum 12 durchgeführt werden.

### c) Photovoltaisch aktive Si-Schicht

Auf die so hergestellte kristallisierte Keimschicht 66 wird eine mit ca. 1·10¹⁶ bis 1·10¹⁷ cm⁻³ Bor dotierte Si-Schicht 68 epitaktisch abgeschieden. Dies kann ebenfalls in dem Reaktionsinnenraum 12 erfolgen. Die Si-Schicht 68 bildet die photovoltaisch aktive Schicht als Basis für eine Dünnschichtsolarzelle. Die Dicke der Epitaxieschicht 68 beträgt zwischen 2 µm und 100 µm und liegt vorzugsweise zwischen 15 µm und 30 µm. Bei Dicken unterhalb von 15 µm ist eine gute Reflexion des Lichtes an der Rückseite der Epitaxieschicht erforderlich, um einen hohen Wirkungsgrad zu erzielen.

### d) Solarzellenprozesse

Zur Herstellung einer Solarzelle wird auf diesem zuvor erläuterten Schichtsystem 62, 64, 66, 68 eine ca. 0,1 µm bis 0,5 µm dicke Phosphor-dotierte Si-Schicht 70 eindiffundiert. Darauf wird ein Frontgitter 72 oder eine transparente Elektrode aufgebracht sowie eine ca. 80 nm dicke Antireflex-Schicht 74 aus TiO₂/MgF oder SiN etc. Hierdurch entsteht eine Dünnschichtsolarzelle, die prinzipiell der Fig. 5 zu entnehmen ist. Sofern ein isolierendes Substrat 62 benutzt oder zumindest die Schicht 64 elektrisch isolierend ausgeführt wird, kann die Solarzelle integriert verschaltet werden.

## Patentansprüche

1. Verfahren zum Behandeln und/oder Beschichten einer Fläche (28) eines in einem Raum (12) angeordneten Substrats, wie eines Halbleiterbauelements wie Solarzelle, durch Beaufschlagen der zur Vertikalen ausgerichteten Fläche mit einem Gas, welches mit der Fläche wechselwirkt und Teilchen enthält, die auf der Fläche eine Schicht bilden und/oder mit der Fläche reagieren, wobei der Raum allseitig von einer Kopffläche (26), einer Bodenfläche (24) und Längsseitenflächen (30) begrenzt ist sowie eine Gaseinlassöffnung (32) und eine Gasauslassöffnung (34) aufweist,
**dadurch gekennzeichnet,**
**dass** der Raum (12) von der Fläche (28) des Substrats (44) begrenzt wird, die parallel oder in etwa parallel zu einer der Längsseitenflächen (30) verläuft, dass das Gas in den Raum in dessen Kopfflächenbereich eingeleitet, nacheinander entlang der einen parallel oder in etwa parallel zu der Fläche des Substrats verlaufenden Längsseitenfläche sowie der Bodenfläche (24) geführt und dabei erwärmt wird, aufgrund der Erwärmung durch Konvektion im Wesentlichen laminar entlang der Fläche des Substrats strömt und der unmittelbar entlang der Fläche des Substrats strömende Teil des Gases im Kopfflächenbereich des Raums abgeführt und der verbleibende Teil des Gases mit neu eingeleitetem Gas vermischt und wieder in dem Raum im Kreislauf geführt wird, wobei die Fläche (28) des Substrats (44) zur Vertikalen unter einem Winkel α mit 0° ≤ α < 90° ausgerichtet wird.

2. Verfahren nach Anspruch 1,
**dadurch gekennzeichnet,**
**dass** die Fläche (28) des Substrats (44) zur Vertikalen unter einem Winkel α mit 0° ≤ α ≤ 60° ausgerichtet wird.

3. Verfahren nach Anspruch 1 oder 2,
**dadurch gekennzeichnet,**
**dass** der aus dem Raum (12) abgeführte Teil des Gases eine Schichtdicke aufweist, die kleiner als dreifache Diffusionszonenbreite, vorzugsweise etwa der Diffusionszonenbreite ist, in der sich mit der Fläche des Substrats wechselwirkende Teilchen befinden.

4. Verfahren nach einem der Ansprüche 1 bis 3,
**dadurch gekennzeichnet,**
**dass** das Gas mit einer Temperatur T₁ in den Raum eingeleitet wird, die geringer als die Temperatur T₂ der zu behandelnden bzw. zu beschichtenden Fläche (28) des Substrats (44) ist.

5. Verfahren nach einem der Ansprüche 1 bis 4,
**dadurch gekennzeichnet,**
**dass** die parallel oder in etwa parallel zur Fläche (28) des Substrats (44) verlaufende Längsseitenfläche (30) des Raums (12) gekühlt wird und/oder die Fläche mittels Infrarotstrahler, Mikrowellen oder induktiv erwärmt wird.

6. Verfahren nach einem der Ansprüche 1 bis 5,
**dadurch gekennzeichnet,**
**dass** das Gas im Kopfbereich des Raums (12) mit einer Temperatur eingeleitet wird, aufgrund der das Gas schwerkraftbedingt entlang der parallel oder in etwa parallel zur Fläche (28) des Substrats (44) verlaufenden Längsseitenfläche (30) strömt und im Bereich dieser und/oder im Bodenbereich des Raums erwärmt wird und sodann konvektionsbedingt entlang der Fläche des Substrats strömt.

7. Verfahren nach einem der Ansprüche 1 bis 6,
**dadurch gekennzeichnet,**
**dass** zum Abscheiden einer siliziumcarbid- und/oder siliziumnitridhaltigen Schicht als Gas ein Gasgemisch von CH₃SiCl₃ und H₂ und/oder NH₃ bzw. SiH₂Cl₂, SiHCl₃, SiCl₄ und H₂ und/oder NH₃ entlang der Fläche (28) des Substrats (44) strömt.

8. Verfahren nach einem der Ansprüche 1 bis 6,
**dadurch gekennzeichnet,**
**dass** zum Abscheiden einer Siliziumschicht auf der Fläche (28) des Substrats (44) ein Gasgemisch von SiHCl₃ und H₂ laminar entlang der Fläche strömt.

9. Verfahren nach Anspruch 7 oder 8,
**dadurch gekennzeichnet,**
**dass** dem Gasgemisch ein Dotiergas bestehend vorzugsweise aus Diboran, Bortrichlorid, Aluminiumtrichlorid, Galliumchlorid oder Indiumchlorid in geeigneter Dosierung beigemischt wird.

10. Verfahren nach einem der Ansprüche 1 bis 6,
**dadurch gekennzeichnet,**
**dass** zum Abscheiden einer SiC-Zwischenschicht auf dem Substrat (44) ein Gasgemisch aus Methyltrichlorsilan und H₂ unter Zugabe von Stickstoff entlang der Fläche (28) strömt.

11. Verfahren nach einem der Ansprüche 1 bis 10,
**dadurch gekennzeichnet,**
**dass** als Substrat (44) ein Glassubstrat verwendet wird und dass zum Ausbilden einer CuInGaSe₂-Schicht auf dem Glassubstrat eine Cu-, In-, Ga-Schicht abgeschieden und entlang dieser ein H₂Se enthaltendes Gas geführt wird.

12. Verfahren nach einem der Ansprüche 1 bis 11,
**dadurch gekennzeichnet,**
**dass** als Substrat (44) ein Glassubstrat verwendet wird und dass zur Ausbildung einer CuInGaSe₂-Schicht auf dem Glassubstrat eine Cu-, In-, Ga-Schicht ausgebildet wird und entlang dieser ein H₂Se enthaltendes Gas geführt wird.

13. Verfahren nach einem der Ansprüche 1 bis 12,
**dadurch gekennzeichnet,**
**dass** auf einem Glassubstrat als das Substrat (44) ein Zinntetrachlorid und ein H₂O enthaltendes Gasgemisch zur Bildung einer Zinnoxidschicht geführt wird

14. Verfahren nach einem der Ansprüche 1 bis 13,
**dadurch gekennzeichnet,**
**dass** auf einem Glassubstrat als das Substrat (44) ein Siliziumtetrachlorid und ein H₂O enthaltendes Gasgemisch zur Bildung einer Siliziumoxidschicht geführt wird

15. Verfahren nach einem der Ansprüche 1 bis 14,
**dadurch gekennzeichnet,**
**dass** das Substrat (44) eine Siliziumschichtaufweist, entlang der ein POCl₃-haltiges Gas geführt wird und dass so gebildete Phosphorglasschicht zur Eindiffusion von Phosphor getempert wird.

16. Verfahren nach einem der Ansprüche 1 bis 15,
**dadurch gekennzeichnet,**
**dass** die Fläche (28) des Substrats (44) oder eine auf diese aufgetragene Schicht durch entlang dieser strömendes HCl-haltiges Gas abgetragen wird

17. Verfahren nach einem der Ansprüche 1 bis 16,
**dadurch gekennzeichnet,**
**dass** die Fläche (28) des Substrats (44) oder eine auf diese aufgetragene Schicht durch entlang dieser strömendes HF- oder HCI-haltiges Gas abgetragen wird

18. Verfahren nach einem der Ansprüche 1 bis 17,
**dadurch gekennzeichnet,**
**dass** eine auf dem Substrat (44) vorhandene Siliziumoxid-Schicht durch entlang dieser strömendes HF- und/oder H₂O-haltiges Gas abgetragen wird

19. Verfahren nach einem der Ansprüche 1 bis 18,
**dadurch gekennzeichnet,**
**dass** eine auf dem Substrat (44) vorhandene Siliziumoxid-Schicht durch entlang dieser strömendes H₂-haltiges Gas bei einer Temperatur T mit T ≥ 1000 °C abgetragen wird.

20. Verfahren nach einem der Ansprüche 1 bis 19 zur Herstellung eines Halbleiterschichtsystems,
**dadurch gekennzeichnet,**
**dass** auf ein Substrat (44) wie Silizium, Keramik oder Graphit zunächst eine SiC- und/oder Siliziumnitrid enthaltende Schicht bei einer Substrattemperatur von 900 °C bis 2000 °C, insbesondere von 1200 °C bis 1600 °C durch CVD abgeschieden wird, auf so gebildete Schicht eine mit einem Element der Gruppe III des Periodensystems dotierte Siliziumschicht (p⁺) aufgetragen wird, diese anschließend durch Aufschmelzen kristallisiert und sodann auf die Kristallbereiche im Bereich von vorzugsweise zwischen 0,1 mm und 10 mm aufweisende Schicht epitaktisch eine photoempfindliche Siliziumschicht aufgetragen wird, wobei insbesondere auf die epitaxierte Siliziumschicht ein pn-Übergang bzw. auf so gebildetes Schichtsystem ein Frontkontakt und gegebenenfalls eine Antireflexschicht ausgebildet wird.

21. Verfahren nach Anspruch 20,
**dadurch gekennzeichnet,**
**dass** vor Aufschmelzen der mit einem Element der Gruppe III des Periodensystems dotierten Siliziumschicht auf diese eine vorzugsweise 0,1 µm bis 5 µm, insbesondere 1 µm bis 2 µm dicke Siliziumoxid-Schicht aufgetragen wird und diese nach insbesondere Aufschmelzen nach dem Zonenschmelzverfahren rekristallisierte dotierte Siliziumschicht mit HF- und/oder H₂-haltigem Gas weggeätzt wird zur Bildung einer Keimschicht mit multikristalliner Struktur mit insbesondere Körnern einer Erstreckung zwischen 0,1 - 10 mm.

22. Vorrichtung zum Beschichten und/oder Behandeln einer Fläche (28) eines Substrats (44) durch Beaufschlagen der Fläche mit einem Gas mit für die Beschichtung bzw. Behandlung erforderlichen Teilchen umfassend einen Raum (12), der allseitig von einer Kopffläche (26), einer Bodenfläche (24) sowie Längsseitenflächen (30) begrenzt ist und eine Gaseinlassöffnung (32) und eine Gasauslassöffnung (34) aufweist, sowie zumindest eine die Fläche erwärmende Wärmequelle (52, 54),
**dadurch gekennzeichnet,**
**dass** die Fläche (28) des Substrats (44) Begrenzungsfläche des Raums (12) ist dass die Fläche parallel oder in etwa parallel zu einer der Längsseitenflächen (30) verläuft, dass die Fläche unter einem Winkel α mit 0° ≤ α < 90° zur Vertikalen verläuft und dass die Gaseinlass- und die Gasauslassöffnung (32, 34) derart im Kopfbereich des Raums (12) angeordnet sind, dass der unmittelbar entlang der Fläche des Substrats strömende Teil des Gases im Kopfflächenbereich des Raums abgeführt und der verbleibende Teil des Gases mit neu eingeleitetem Gas vermischt und wieder in dem Raum im Kreislauf geführt werden kann.

23. Vorrichtung nach Anspruch 21,
**dadurch gekennzeichnet,**
**dass** die Gasauslassöffnung (34) sich nahezu über gesamte Breite der Fläche (28) und parallel zu dieser verlaufend erstreckt

24. Vorrichtung nach Ansprüche 20 oder 21,
**dadurch gekennzeichnet,**
**dass** die Gaseinlassöffnung (32) im Bereich der parallel zu der Fläche (28) des Substrats (44) verlaufenden Längsseitenfläche (30) des Raums (12) verläuft.

25. Vorrichtung nach einem der Ansprüche 22 bis 24,
**dadurch gekennzeichnet,**
**dass** die Fläche (28) des Substrats (44) eine Öffnung des Raums (12) insbesondere dichtend verschließt.

26. Vorrichtung nach zumindest einem der Ansprüche 22 bis 25,
**dadurch gekennzeichnet,**
**dass** der Raum (12) gegenüber seiner Umgebung auf einen Überdruck einstellbar ist.

27. Vorrichtung nach einem der Ansprüche 22 bis 26,
**dadurch gekennzeichnet,**
**dass** die Gaseinlassöffnung (32) und/oder Gasauslassöffnung (34) gegenüber dem Raum (12) über ein Abweiselement (56) abgedeckt ist, das sowohl beabstandet gegenüber der Fläche (28) des Substrats (44) als auch gegenüber der parallel oder in etwa parallel zu der Fläche verlaufenden Längsseitenfläche (30) beabstandet verläuft.

## Claims

1. Method for treating and/or coating a surface (28) of a substrate, such as semiconductor element as solar cell, arranged in a chamber (12) by acting with a gas upon the surface aligned to the vertical, said gas interacting with the surface and containing particles that form a coating on the surface and/or react with the surface, whereby the chamber is limited at all sides by a top surface (26), a bottom surface (24) and longitudinal side surfaces (30) and has a gas intake port (32) and a gas outlet port (34),
**characterized in**
**that** the chamber (12) is limited by the surface (28) of the substrate (44) that runs parallel or approximately parallel to one of the longitudinal side surfaces (30), that the gas is led into the chamber into its top surface region, guided in succession along both the longitudinal side surface, that runs parallel or approximately parallel to the surface of the substrate, and the bottom surface (24) and is heated thereby, that because of the heating by convection the gas flows substantially laminar along the surface of the substrate and the portion of the gas flowing directly along the surface of the substrate is drawn out in the top surface region of the chamber and the remaining portion of the gas is mixed with gas passed in newly and, again, is recirculated, whereby the surface (28) of the substrate (44) is oriented to the vertical at an angle α wherein 0° ≤ α < 90°.

2. Method according to claim 1,
**characterized in**
**that** the surface (28) of the substrate (44) is oriented to the vertical at an angle α wherein 0° ≤ α < 60°.

3. Method according to claim 1 or 2,
**characterized in**
**that** the portion of the gas drawn out of the chamber (12) has a layer thickness that is less than three times the diffusion zone width, preferably approximately the diffusion zone width, which contains particles that interact with the surface of the substrate.

4. Method according to one of claims 1 to 3,
**characterized in**
**that** the gas is introduced into the chamber at a temperature T₁, which is lower than the temperature T₂ of the surface (28) of the substrate (44) to be treated and coated, respectively.

5. Method according to one of claims 1 to 4,
**characterized in**
**that** longitudinal side surface (30) of the chamber (12), that runs parallel or approximately parallel to the surface (28) of the substrate (44), is cooled and/or the surface is heated by infrared radiators, microwaves or inductively.

6. Method according to one of claims 1 to 5,
**characterized in**
**that** the gas is introduced in the top region of the chamber (12) at a temperature causing the gas by force of gravity to flow along the longitudinal surface side (30), that runs parallel or approximately parallel to the surface (28) of the substrate (44), and that the gas is heated in this region and/or in the bottom region of the chamber, causing it by force of convection to flow along the surface of the object.

7. Method according to one of claims 1 to 6,
**characterized in**
**that** to deposit a film containing silicon carbide and/or silicon nitride, as gas a gas mixture of CH₃SiCl₃ and H₂ and/or NH₃ or SiH₂Cl₂, SiHCl₃, SiCl₄ and H₂ and/or NH₃ flows along the surface (28) of the substrate (44).

8. Method according to one of claims 1 to 6,
**characterized in**
**that** to deposit a silicon film onto the surface (28) of the substrate (44) a gas mixture of SiHCl₃ and H₂ flows laminar along the surface.

9. Method according to claim 7 or 8,
**characterized in**
**that** a doping gas preferably consisting of a suitable amount of diborane, boron trichloride, aluminum trichloride, gallium chloride or indium chloride is added to the gas mixture.

10. Method according to one of claims 1 to 6,
**characterized in**
**that** to deposit a SiC-intermediate layer onto the substrate (44) a gas mixture consisting of methyl trichlorsilan and H₂ flows along the surface (28) while adding nitrogen.

11. Method according to one of claims 1 to 10,
**characterized in**
**that** as substrate (44) a glass substrate is used and that to form a CuInGaSe₂ layer on the glass substrate a Cu-, In, Ga-layer is deposited and along this a gas containing H₂Se is directed.

12. Method according to one of claims 1 to 11,
**characterized in**
**that** as substrate (44) a glass substrate is used and that to form a CuInGaSe₂ layer on the glass substrate a Cu-, In, Ga-layer is formed and along this a gas containing H₂Se is directed.

13. Method according to one of claims 1 to 12,
**characterized in**
**that** on a glass substrate as the substrate (44) a gas mixture containing a tin tetrachloride and an H₂O is directed to form a tin oxide layer.

14. Method according to one of claims 1 to 13,
**characterized in**
**that** on a glass substrate as the substrate (44) a gas mixture containing a silicon tetrachloride and an H₂O is directed to form a silicon oxide film.

15. Method according to one of claims 1 to 14,
**characterized in**
**that** the substrate (44) comprises a silicon layer along which a gas containing POCl₃ is directed and that phosphorus glass layer formed in this manner is tempered for the inward diffusion of phosphorous.

16. Method according to one of claims 1 to 15,
**characterized in**
**that** the surface (28) of the substrate (44) or a film applied to this surface is removed via a gas containing HCl flowing along this surface.

17. Method according to one of claims 1 to 16,
**characterized in**
**that** the surface (28) of the substrate (44) or a film applied to this surface is removed via a gas containing HF or HCl flowing along this surface.

18. Method according to one of claims 1 to 17,
**characterized in**
**that** a silicon oxide film on the substrate (44) is removed via a gas containing HF and/or H₂O flowing along this surface.

19. Method according to one of claims 1 to 18,
**characterized in**
**that** a silicon oxide film on the substrate (44) is removed via a gas containing H₂ at a temperature T, wherein T ≥ 1000° C.

20. Method according to one of claims 1 to 19 for producing a semiconductor system of layers,
**characterized in**
**that** on a substrate (44) such as silicon, ceramic, or graphite first a layer containing SiC and/or silicon nitride is deposited via CVD, at a substrate temperature of 900° C to 2000° C, preferably 1200° C to 1600° C; a silicon film (p⁺) that is doped with an element from Group III of the periodic table is applied to the layer formed in this manner; this is then crystallized via melting, after which a photosensitive silicon film is applied epitaxially to the crystalline areas within a range of preferably between 0,1 mm and 10 mm, whereby in particular a pn transition is formed on the epitaxial silicon layer and, respectively, a front contact layer and if necessary an antireflective layer is formed on the system of layers created in this manner.

21. Method according to claim 20,
**characterized in**
**that** prior to the melting on of the silicon film that is doped with an element of Group III of the periodic table, a preferably 0.1 µm to 5 µm, especially 1 µm to 2 µm, thick silicon oxide film is applied; this silicon film, which has recrystallized as a result of melting, preferably via a zone melting process, and is doped, is etched away via a gas containing HF and/or H₂, in order to form a nucleation layer having a multicrystalline structure, whose particles preferably extend between 0.1 - 10 mm.

22. Device for coating and/or treating a surface (28) of a substrate (44) by supplying said surface with a gas with particles necessary for the coating or treatment, comprising a chamber (12) that is limited at all sides by a top surface (26), a bottom surface (24) as well as longitudinal side surfaces (30) and has a gas intake port (32) and a gas outlet port (34) as well as at least one heat source (52, 54) heating the surface,
**characterized in**
**that** the surface (28) of the substrate (44) forms limiting surface of the chamber (12), that the surface runs parallel or approximately parallel to one of the longitudinal side surfaces (30), that the surface runs under an angle α relative to the vertical, wherein 0° ≤ α< 90°, and that the gas intake port and the gas outlet port (32, 34) are positioned such in the top region of the chamber (12), that the portion of the gas flowing directly along the surface of the substrate is carried away in the top surface region of the chamber and the remaining portion of the gas is mixed with gas newly introduced and, again, can be recirculated in the chamber.

23. Device according to claim 22,
**characterized in**
**that** the gas outlet port (34) extends nearly over the entire width of the surface (28) and parallel to said surface.

24. Device according to claim 22 or 23,
**characterized in**
**that** the gas intake port (32) extends in the region of the longitudinal side surface (30) of the chamber (12) that runs parallel to the surface (28) of the substrate (44).

25. Device according to one of claims 22 to 24,
**characterized in**
**that** the surface (28) of the substrate (44) closes an opening of the chamber (12) particularly sealing.

26. Device according to one of claims 22 to 25,
**characterized in**
**that** the chamber (12) relative to its surroundings is adjustable to overpressure.

27. Device according to one of claims 22 to 26,
**characterized in**
**that** the gas intake port (32) and/or gas outlet port (34) is covered in relation to the chamber (12) over a deflecting element (56) that runs at a distance relative to both the surface (28) of the substrate (44) and the longitudinal side surface (30) running in parallel or essentially parallel to the surface.

## Revendications

1. Procédé de traitement et/ou de revêtement d'une surface (28) d'un substrat disposé dans une chambre (12), par exemple un composant semiconducteur tel qu'une cellule solaire, par application sur la surface orientée par rapport à la verticale d'un gaz interactif avec la surface et que contient des particules formant une couche sur la surface et/ou réagissant avec la surface, la chambre étant délimitée de tous les côtés par une surface de tête (26), une surface de fond (24) et des surfaces longitudinales latérales (30) en présentant une ouverture d'entrée de gaz (32) et une ouverture de sortie de gaz (34),
**caractérisé en ce que**
la chambre (12) est délimitée par la surface (28) du substrat (44) parallèle ou sensiblement parallèle à une des surfaces longitudinales latérales (30), et le gaz est introduit, dans la zone de surface de tête de la chambre, appliqué successivement le long d'une surface longitudinale latérale parallèle ou sensiblement parallèle à la surface du substrat ainsi que le long de la surface de fond (24), pour y être chauffé, s'écoule en raison de l'échauffement par convection essentiellement de façon laminaire le long de la surface du substrat, et la partie du gaz s'écoulant directement le long de la surface du substrat est évacuée dans la zone de surface de tête de la chambre, et on recycle dans la chambre la partie restante du gaz mélangée avec du gaz neuf introduit, la surface (28) du substrat (44) étant orientée par rapport à la verticale sous un angle α de 0°≤α< 90°.

2. Procédé selon la revendication 1,
**caractérisé en ce que**
la surface (28) du substrat (44) fais un angle α de 0°≤α≤60°par rapport à la verticale.

3. Procédé selon la revendication 1 ou 2,
**caractérisé en ce que**
la partie du gaz évacuée de la chambre (12) présente une épaisseur de couche inférieure à trois fois la largeur de zone de diffusion, de préférence sensiblement la largeur de zone de diffusion dans laquelle se trouvent des particules en interaction avec la surface du substrat.

4. Procédé selon l'une des revendications 1 à 3,
**caractérisé en ce que**
le gaz est introduit dans la chambre à une température Tᵢ inférieure à la température T₂ de la surface (28) du substrat (44) à traiter ou à revêtir.

5. Procédé selon l'une des revendications 1 à 4,
**caractérisé en ce que**
la surface longitudinale latérale (30) de la chambre (12) s'étendant parallèlement ou sensiblement parallèlement à la surface (28) du substrat (44) est refroidie, et/ou chauffée au moyen de rayons infrarouges, de micro-ondes ou de façon inductive.

6. Procédé selon l'une des revendications 1 à 5,
**caractérisé en ce que**
le gaz est introduit dans la zone de tête de la chambre (12) à une température permettant au gaz de s'écouler par force centrifuge le long de la surface longitudinale latérale (30) parallèle ou sensiblement parallèle à la surface (28) du substrat (44), pour être chauffé dans la zone de celle-ci et/ou dans la zone de fond de la chambre puis s'écouler par convection le long de la surface du substrat.

7. Procédé selon l'une des revendications 1 à 6,
**caractérisé en ce que**
pour déposer une couche contenant du carbure de silicium et/ ou du nitrure de silicium, le gaz s'écoulant le long de la surface (28) du substrat (44) est un mélange gazeux composé de CH₃SiCl₃ et H₂, et/ou NH₃ ou SiH₂Cl₂, SiHCl₃, SiCl₄ et H₂ et/ou NH₃.

8. Procédé selon l'une des revendications 1 à 6,
**caractérisé en ce que**
pour déposer une couche de silicium sur la surface (28) du substrat (44) un mélange gazeux de SiHCl₃ et H₂ s'écoule de façon laminaire le long de la surface.

9. Procédé selon la revendication 7 ou 8,
**caractérisé en ce qu'**
on ajoute au mélange gazeux un gaz de dopage, de préférence du diborane, du trichlorure de bore, du trichlorure d'aluminium, du chlorure de gallium ou du chlorure d'indium, selon un dosage approprié.

10. Procédé selon l'une des revendications 1 à 6,
**caractérisé en ce que**
pour déposer une couche intermédiaire de SiC sur le substrat (44) un mélange gazeux de trichlorure de silane méthylique et de H₂ complété par de l'azote s'écoule le long de la surface (28).

11. Procédé selon l'une des revendications 1 à 10,
**caractérisé en ce que**
comme substrat (44) on utilise un substrat en verre, et pour former une couche de CuInGaSe₂ on dépose sur le substrat en verre une couche de Cu, In, Ga et on applique le long de celle-ci un gaz contenant du H₂Se.

12. Procédé selon l'une des revendications 1 à 11,
**caractérisé en ce que**
comme substrat (44) on utilise un substrat en verre, et pour former une couche de CuInGaSe₂ on forme sur le substrat en verre une couche de Cu, In, Ga et on applique le long de celle-ci un gaz contenant du H₂Se.

13. Procédé selon l'une des revendications 1 à 12,
**caractérisé en ce que**
sur un substrat en verre servant de substrat (44) on applique un mélange gazeux contenant du tétrachlorure d'étain et du H₂O pour former une couche d'oxyde d'étain.

14. Procédé selon l'une des revendications 1 à 13,
**caractérisé en ce que**
sur un substrat en verre servant de substrat (44) on applique un mélange gazeux contenant du tétrachlorure de silicium et du H₂O pour former une couche d'oxyde de silicium.

15. Procédé selon l'une des revendications 1 à 14,
**caractérisé en ce que**
le substrat (44) présente une couche de silicium le long de laquelle on applique un gaz contenant du POCl₃, et on trempe la couche en verre phosphoreux ainsi formée pour la diffusion de phosphore.

16. Procédé selon l'une des revendications 1 à 15,
**caractérisé en ce que**
la surface (28) du substrat (44) ou une couche déposée sur celle-ci est enlevée par du gaz contenant du HCl s'écoulant le long de celle-ci.

17. Procédé selon l'une des revendications 1 à 16,
**caractérisé en ce que**
la surface (28) du substrat (44) ou une couche déposée sur celle-ci est enlevée par du gaz contenant du HF ou du HCI s'écoulant le long de celle-ci.

18. Procédé selon l'une des revendications 1 à 17,
**caractérisé en ce qu'**
une couche d'oxyde de silicium sur le substrat (44) est enlevée par du gaz contenant du HF et/ou du H₂O s'écoulant le long de celle-ci.

19. Procédé selon l'une des revendications 1 à 18,
**caractérisé en ce qu'**
une couche d'oxyde de silicium sur le substrat (44) est enlevée par du gaz contenant du H₂ s'écoulant le long de celle-ci, à une température T≥ 1000°C.

20. Procédé selon l'une des revendications 1 à 19 pour fabriquer un système de couches semi-conductrices,
**caractérisé en ce qu'**
on dépose par dépôt CVD sur un substrat (44) tel que du silicium, une céramique ou du graphite d'abord une couche contenant du nitrure de SiC et/ou de silicium à une température de substrat entre 900°C et 2000°C, en particulier entre 1200°C et 1600°C, on applique sur la couche ainsi formée une couche de silicium dopée (p⁺) avec un élément du groupe III du système périodique, on cristallise celle-ci ensuite par fusion, puis on applique de façon épitaxiale une couche de silicium photosensible sur la couche présentant les zones de cristal d'une épaisseur de préférence entre 0,1 mm et 10 mm, en formant en particulier sur la zone de silicium épitaxiale un passage pn ou sur le système de couches ainsi formé un contact frontal et le cas échéant une couche anti-réflexion.

21. Procédé selon la revendication 20,
**caractérisé en ce qu'**
avant la fusion de la couche de silicium dopée avec un élément du groupe III du système périodique, on applique sur celle-ci une couche d'oxyde de silicium d'une épaisseur de préférence entre 0,1 µm et 5 µm, en particulier entre 1 µm et 2 µm, et on décape avec du gaz contenant du HF et/ou du H₂ cette couche de silicium dopée recristallisée, après en particulier la fusion selon le procédé de zones fondues, pour former une couche de germination d'une structure polycristalline avec en particulier des grains d'une longueur entre 0,1 et 10 mm.

22. Dispositif pour revêtir et/ou traiter une surface (28) d'un substrat (44) en appliquant sur la surface un gaz contenant des particules nécessaires pour le revêtement ou le traitement, comprenant une espace (12) délimitée de tous les côtés par une surface de tête (26), une surface de fond (24) et des surfaces longitudinales latérales (30) et présentant une ouverture d'entrée de gaz (32) et une ouverture de sortie de gaz (34) ainsi qu'au moins une source de chaleur (52, 54) chauffant la surface,
**caractérisé en ce que**
la surface (28) du substrat (44) est la surface de délimitation de la chambre (12), la surface s'étend parallèlement ou sensiblement parallèlement à l'une des surfaces longitudinales latérales (30), la surface s'étend sous un angle α de 0°≤α< 90° par rapport à la verticale, et les ouvertures d'entrée et de sortie de gaz (32, 34) sont disposées dans la zone de tête de la chambre (12) pouvoir évacuer la partie du gaz s'écoulant directement le long de la surface du substrat dans la zone de surface de tête de la chambre, et recycler dans la chambre la partie restante du gaz mélangée avec du gaz neuf introduit.

23. Dispositif selon la revendication 21,
**caractérisé en ce que**
l'ouverture de sortie de gaz (34) s'étend pratiquement sur toute la largeur de la surface (28) et parallèlement à celle-ci.

24. Dispositif selon les revendications 20 ou 21,
**caractérisé en ce que**
l'ouverture d'entrée de gaz (32) s'étend dans la zone de la surface longitudinale latérale (30) de la chambre (12) s'étendant parallèlement à la surface (28) du substrat (44).

25. Dispositif selon l'une des revendications 22 à 24,
**caractérisé en ce que**
la surface (28) du substrat (44) obture une ouverture de la chambre (12), en particulier de façon étanche.

26. Dispositif selon au moins l'une des revendications 22 à 25,
**caractérisé en ce que**
la chambre (12) est réglable sur une surpression par rapport à son environnement.

27. Dispositif selon l'une des revendications 22 à 26,
**caractérisé en ce que**
l'ouverture d'entrée de gaz (32) et/ou l'ouverture de sortie de gaz (34) sont recouvertes par rapport à la chambre (12) par un élément déflecteur (56) écarté aussi bien de la surface (28) du substrat (44) que de la surface longitudinale latérale (30) parallèle ou sensiblement parallèle à cette surface.
